# EUROPEAN PATENT APPLICATION

(11) **EP 4 553 614 A1**
(43) Date of publication of application: **14.05.2025**
(21) Application number: 23208230.5
(22) Date of filing: 07.11.2023
(51) Int. Cl.: G06F 1/32, H03K 17/945, H03K 17/95, G06F 3/01

(54) **PROXIMITY DETECTOR ARRANGEMENT**

(71) Applicant: The Swatch Group Research and Development Ltd, 2074 Marin (CH)
(72) Inventor: CASAGRANDE, Arnaud, 2014 Bôle (CH); AREND, Jean-Luc, 2035 Corcelles (CH)
(74) Representative: ICB SA

(57) **Abstract**

In one aspect, the present invention concerns a wireless proximity detector arrangement (10) comprising:
- at least one antenna (12),
- an impedance sensing circuit (14) coupled to the antenna (12) and operable to quantitatively measure variations of an antenna impedance over time, and
- a controller (30) connected to the impedance sensing circuit (14) and operable to at least one of selectively deactivating and selectively activating the impedance sensing circuit (14) for a predefined time interval.

## Description

### Field of the invention

In one aspect, the present invention relates to a wireless proximity detector arrangement. In further aspects, the invention relates to an electronic device comprising a user interface equipped with a wireless proximity detector arrangement. In another aspect, the present invention relates to a method of detecting and/or quantitatively measuring a spatiotemporal movement of an object relative to a wireless proximity detector arrangement.

### Background

Some wireless or contactless motion detection systems for user interfaces make use of the radar principle, in which a microwave is generated, reflected by an object to be detected and finally received by a receiver in order to detect a movement or distance between the receiver and the reflecting object. Document EP 2 871 590 B1 also discloses a portable system for user-controlled audio output or display output, comprising a wearable physical activity monitoring device with a wireless proximity detection module. There, the wireless proximity detection module is configured to perform a measuring of the proximity of an input control entity by measuring a change in an antenna impedance or in an antenna resonance frequency caused by moving the input control entity with respect to the at least one antenna.

In view of the above, it is a particular aim, especially for mobile electronic devices, to reduce power consumption and to extend the battery lifetime while still providing a highly precise and reliable proximity detection and/or motion detection.

### Summary of the invention

The above-mentioned object will be solved and suitably addressed by a wireless proximity detector arrangement, by an electronic device and by a method of detecting and/or quantitatively measuring a spatiotemporal movement of an object in accordance to the features of the independent claims. Preferred embodiments or solutions are subject matter of respective dependent claims.

According to one aspect, there is provided a wireless proximity detector arrangement. The wireless proximity detector arrangement comprises at least one antenna. The detector arrangement further comprises an impedance sensing circuit coupled to the antenna and operable to quantitatively measure variations of an antenna impedance over time. The wireless proximity detector arrangement further comprises a controller connected to the impedance sensing circuit and operable to at least one of selectively deactivating and selectively activating the impedance sensing circuit for a predefined time interval.

By temporally deactivating the impedance sensing circuit respective power or energy for operating the impedance sensing circuit can be saved. This way, overall energy or power consumption of the impedance sensing circuit can be reduced and in case of a mobile electronic device, which might be driven or operated by a battery, the battery lifetime can be extended.

Typically and according to a further example, the controller is operable to regularly deactivate and to regularly activate the impedance sensing circuit. For instance, activation of the impedance sensing circuit can be conducted on the basis of a predefined schedule. With some examples, the controller may be operable to clock the impedance sensing circuit, such that the impedance sensing circuit is activated at a predefined point of time or after lapse of a predefined time interval.

The controller may be also operable to keep or to maintain the impedance sensing circuit in the activated mode or activated state for a predefined time interval. After lapse of this activation time interval the controller may be also operable to deactivate the impedance sensing circuit for and/or during a predefined inactivity time interval.

Hence talking in terms of a periodic or regular activation and deactivation of the impedance sensing circuit the time interval during which the impedance sensing circuit is inactive may be denoted as an inactive detection time interval. Time periods, during which the impedance sensing circuit is active or is activated by the controller may be denoted as active detection time interval. The sum of the active detection time intervals and the sum of the inactive detection time intervals equals an overall detection time interval, i.e. a time interval which is split into interval fractions, during which the impedance sensing circuit is active or inactive, respectively.

According to some examples, the active detection time interval is smaller than the inactive detection time interval. In this way, the electrical power consumption of the wireless proximity detector arrangement and in particular of the impedance sensing circuit can be reduced. With some examples, the sampling times, according to which the impedance sensing circuit is regularly activated may be as small as a few tenth of microseconds (µs). Hence, a sampling period, hence the sum of the active detection time interval and the inactive detection time interval may sum up to about less than 10 ms, less than 15 ms, less than 20 ms or less than 50 ms. The inactive detection time interval may be larger than the active detection time interval. In some examples, the sampling period may be about 10 ms and the active detection time interval may be as small as than 100 µs.

For instance and with a sampling period of about 10 ms, the controller may be operable to deactivate the impedance sensing circuit during time durations of about 9.9 ms and to activate the impedance sensing circuit during a consecutive time interval of about 100 µs. Thereafter, the controller may be operable to switch the impedance sensing circuit into the inactive mode.

The wireless proximity detector arrangement, in particular the controller thereof is operable to repeatedly and to regularly sample, i.e. to regularly activate the impedance sensing circuit so as to quantitatively measure a distance between a moving or non-moving object and the at least one antenna of the wireless proximity detector arrangement. When activated the impedance sensing circuit is operable to measure variations of the antenna impedance over time. The controller may be further operable to derive movement or position data being indicative of a relative position or movement of the object relative to the antenna on the basis of the analysis of the impedance variations measured during numerous consecutive active detection time intervals of the impedance sensing circuit. This way, the controller is capable to derive at least one of a position and a movement of the object that has an influence of the antenna impedance when moved in close proximity to the at least one antenna.

In some examples, the impedance sensing circuit is operable to quantitatively measure variations of the antenna impedance over time. In this context impedance variations do not only include variations of a complex electrical resistance of the antenna but also include variations of the resonance frequency or frequency of the antenna or of a respective antenna circuit coupled to the antenna.

According to a further example, the controller of the wireless proximity detector is operable to selectively activate the impedance sensing circuit in a pulsed mode. Also, the impedance sensing circuit may be only activated for predefined time intervals and/or at predefined points of time, e.g. in accordance to a predefined sampling schedule. This way and when operating the impedance sensing circuit in a pulsed mode energy can be saved compared to an operational state, wherein the impedance sensing circuit is driven or operated continuously.

According to another example, the impedance sensing circuit comprises a measuring oscillator coupled to the antenna. Variations of the antenna impedance are quantitatively measurable by measuring at least one of a control signal for operating the measuring oscillator, an amplitude signal of the measuring oscillator and a frequency signal of the measuring oscillator. Here, and in one example, the at least one antenna may be driven at a radiofrequency (RF) signal, e.g. in the 2.44 GHz band. By way of the oscillator, the antenna can be operated or driven in an RF transmission mode, where objects in direct vicinity, e.g. in the nearfield of the antenna may have a measurable influence on the impedance of the antenna.

Moreover and by measuring the impedance or a function of the antenna impedance the movement or position of the object in close vicinity to the antenna, i.e. in the near field of the antenna can be detected, characterized and/or quantitatively measured.

According to a further example, the measuring oscillator is coupled to an automatic gain controller. The automatic gain controller is operable to fix a signal amplitude of the measuring oscillator, which is connected or coupled to the at least one antenna. In response to an object moving or getting in close vicinity to the at least one antenna, e.g. moving into the nearfield of the antenna, a respective modification of the antenna impedance will evolve. This impedance modification as induced by the moving object in the nearfield of antenna typically leads to a respective modification or change of the driving voltage or driving current of the oscillator. By way of the automatic gain controller a control signal for operating the oscillator, e.g. one of a bias current or bias voltage, is automatically adjusted, such that the signal amplitude of the measuring oscillator remains constant. Here and due to variations of the antenna impedance the driving signal for the measuring oscillator is subject to respective changes, which are measurable and which changes are indicative of the variations of the antenna impedance.

According to another example, the automatic gain controller is operable to provide an amplitude control bias current to the measuring oscillator, which amplitude control bias current is subject to measurable variations in response to variations of the antenna impedance. Accordingly, and with the automatic gain controller the bias current or bias voltage of the oscillator coupled or connected to the at least one antenna can be subject to measurable variations, which serve to maintain or to fix the output signal or signal amplitude of the measuring oscillator. These measurable variations of the driving signal for driving the measuring oscillator are directly indicative of impedance modifications of the antenna.

According to another example, the impedance sensing circuit comprises an amplitude detector connected to an output of the measuring oscillator. The amplitude detector allows to operate the measuring oscillator in a different mode compared to the automatic gain controller mode. Here, and according to another example, the measuring oscillator is operable at a constant bias current or constant bias voltage. The amplitude detector is operable to measure variations of a signal amplitude of the measuring oscillator in response to variations of the antenna impedance. Here, an object moving or located in direct vicinity of the at least one antenna, i.e. located in the nearfield of the antenna, may induce variations of the antenna impedance, which, when driven by the measuring oscillator result in measurable variations of a signal amplitude of the measuring oscillator, in particular, when the measuring oscillator is operated by a bias current or bias voltage, which is kept constant or which is fixed.

The amplitude detector is typically connected to an output of the measuring oscillator and is operable to detect variations of the amplitude of the measuring oscillator. The variations of the amplitude of the measuring oscillator may be directly indicative of respective variations of the antenna impedance.

According to another example, the impedance sensing circuit comprises a phase locked loop (PLL), which is coupled to the oscillator and which is coupled to a reference frequency generator. The reference frequency generator is operable to provide a reference frequency signal. By way of the phase locked loop the frequency of the oscillator can be kept or locked to the reference frequency, e.g. the frequency of the reference frequency signal as provided by the reference frequency generator. Variations of the antenna impedance typically induce a shift or variation of the resonance frequency of the antenna, which may induce a frequency control signal of the phase locked loop, which frequency control signal is measurable by the controller and which frequency control signal is hence directly indicative of the impedance variations.

Typically, the phase locked loop comprises a frequency divider connected to a signal output of the oscillator. The output of the frequency divider is provided to a phase comparator. Also, an output of the reference frequency generator is likewise provided to the phase comparator. The phase comparator is operable to compare the frequency, e.g. the operating frequency of the oscillator and the reference frequency. An output of the phase comparator is connected through a loop filter and via a feedback path to the oscillator. Here, the loop filter is may be operable to generate a corrected or a compensating driving signal for the oscillator in order to reduce or to eliminate a phase mismatch or phase offset between the phase of the oscillator signal and the phase of the reference frequency signal. The control signal generated or provided by the loop filter and being operable to reduce a phase or frequency mismatch between the phase or frequency of the oscillator compared to the reference frequency is then directly indicative of impedance variations of the at least one antenna that might be due to an object present or moving in close vicinity to the antenna.

Accordingly and in another example, the phase locked loop is operable to fix a frequency of the oscillator by a frequency control signal derivable by a comparison of the relative phases between an output signal of the oscillator and a reference signal provided by the reference frequency generator. This way, variations of the impedance of the at least one antenna can be directly monitored and/or quantitatively measured by measuring or monitoring the frequency control signal that is present to an input of the measuring oscillator coupled to the phase locked loop.

According to another example, the impedance sensing circuit comprises a frequency counter connected to an output of the oscillator. Here, the measuring oscillator may not be part of a phase locked loop. It may be simply operated on the basis of a rather constant and non-modifying frequency control signal. Any variations in antenna impedance may have a measurable impact on the frequency and/or phase of the measuring oscillator. The frequency counter is particularly operable to directly measure any modifications or alterations of the phase and/or frequency of the measuring oscillator. Here, it is intended that e.g. the controller of the wireless proximity detector arrangement is configured to reset the frequency counter at a predefined time interval and to define a start and stop times, at which frequency counting begins and terminates, respectively.

The frequency counter may be operable to measure a frequency and/or a phase of an input signal obtained from the measuring oscillator, which phase or frequency is directly indicative of any fluctuations or modifications of the phase or frequency compared to a reference frequency or reference phase. This way, the frequency counter might be operable to directly and quantitatively measure any variations of the frequency or phase of the measuring oscillator that are due to impedance variations of the impedance of the at least one antenna.

According to a further example, the oscillator is operable to vary an oscillation frequency in response to impedance variations of the antenna. The frequency counter of the impedance sensing circuit is further operable to quantitatively measure the oscillation frequency variation(s). In this way the frequency counter is directly operable to provide variations of the oscillation frequency that are due to the impedance variation of the at least one antenna. The degree of oscillation frequency variations may directly correlate to the magnitude or degree of impedance variations of the antenna. This way, impedance variations of the antenna can be measured not only qualitatively but also quantitatively. This provides a rather precise measurement of a position, proximity or movement of an object in close proximity to the at least one antenna.

According to another example, the impedance sensing circuit is operable to drive the oscillator in a spread spectrum mode. In the spread spectrum mode the operating or driving signal of the oscillator is generated or provided with a particular bandwidth and is deliberately spread in a frequency domain, resulting in a signal with a wider bandwidth. By way of operating the oscillator in the spread spectrum mode, it can be avoided that in band interfers modify the oscillator amplitude and frequency through frequency pulling effect. Also, the spread modulation is one way to avoid radiating out-of-specification power of the antenna as the measuring oscillator is directly coupled to the at least one antenna.

According to a further example, the controller comprises a neural network and a digital storage or digital memory coupled or connected to the neural network. Moreover, the controller is connected to an output of the impedance sensing circuit in order to derive or to determine a distance or movement characteristics of at least one object in close vicinity to the at least one antenna, which movement or position of the object induces the impedance variation.

The digital storage of the controller is operable to store numerous temporal evolutions of impedance signals. The neural network is configured to map at least one temporal evolution of impedance signals to a characteristic spatiotemporal movement pattern of an object relative to the antenna. The neural network may be operable to provide a best matching between a temporal evolution of impedance signals as measured by the impedance sensing circuit with previously mapped or evolutions of measurement signals that are assigned to respective characteristic spatiotemporal movement patterns of the object relative to the at least one antenna. In this way and since the neural network may provide a constant training as well as a constant or repeated storage of spatiotemporal movement patterns of the object in the digital storage, externally factors, e.g. such as a thermal drift of the impedance sensing circuit may be effectively compensated for.

Moreover, the neural network in combination with the digital storage may allow and provide a complete gesture recognition, i.e. a well-defined spatiotemporal movement pattern of an object moving in a well-defined way or manner relative to the at least one antenna.

Generally, the wireless proximity detector arrangement can be operated and driven with comparatively low energy consumption and the oscillation power just needs to be sufficient to operate at least one of the above-mentioned hardware components: measuring oscillator, frequency divider, phase comparator, filter or counter. It is not necessary that the antenna actually radiates or broadcasts electromagnetic energy.

According to another aspect, there is also provided an electronic device comprising a user interface to control or to modify a function of the electronic device. The user interface comprises a wireless proximity detector arrangement as described above. Insofar, all effects, features and benefits as described above in connection with the wireless proximity detector equally apply to the electronic device; and vice versa.

Typically, the electronic device is a mobile electronic device. It may be operated or driven by a mobile source of energy, such as a battery, or a rechargeable battery. By making use of the wireless proximity detector arrangement as described above, overall power consumption of the electronic device can be reduced. Thus, battery lifetime may be extended in a beneficial manner.

In still another aspect, the present invention also relates to a method of detecting and/or quantitatively measuring a spatiotemporal movement of an object relative to a wireless proximity detector arrangement as described above. The method comprises the steps of a) providing a wireless proximity detector arrangement as described above, b) activating an impedance sensing circuit of the wireless proximity detector arrangement for a predefined time interval, c) quantitatively measuring variations of an antenna impedance over time by way of the impedance sensing circuit coupled to the antenna, of the wireless proximity detector arrangement, and d) deactivating the impedance sensing circuit for a predefined time interval. Optionally and according to a step e) the steps of the b), c) and d) are repeated, e.g. even multiple times. Thereafter or concurrently with the execution of one of the steps b), c), d) or e) a spatiotemporal movement or position of the object relative to the wireless proximity detector arrangement is derived or quantitatively determined on the basis of the variations of the antenna impedance in a step f).

Typically, the method of detecting and/or quantitatively measuring a spatiotemporal movement of an object as described herein is to be conducted by the wireless proximity detector arrangement as described above. Insofar, all features, effects and benefits as described above in connection with the wireless proximity detector arrangement equally apply to the method of detecting and/or quantitatively measuring the spatiotemporal movement of the objected relative to the wireless proximity detector arrangement, e.g. relative to the at least one antenna thereof.

### Brief description of the drawings

In the following numerous examples of the invention will be described in greater detail by making reference to the drawings, in which:
- Fig. 1 schematically illustrates a block diagram of a wireless proximity detector arrangement,
- Fig. 2 shows a diagram illustrating a repeated activation and deactivation of the impedance sensing circuit over time,
- Fig. 3 shows a block diagram of one example of the wireless proximity detector arrangement,
- Fig. 4 shows a block diagram of a solution of operating the measuring oscillator by way of an automatic gain controller,
- Fig. 5 shows another block diagram illustrating another implementation of operating the measuring oscillator,
- Fig. 6 is a block diagram illustrating a phase locked loop connected or coupled to the measuring oscillator,
- Fig. 7 shows a further block diagram of the measuring oscillator connected or coupled to a frequency counter,
- Fig. 8 schematically illustrates a spatial evolution of a complex impedance of a moving object in close vicinity to the at least one antenna,
- Fig. 9 is a further block diagram of the wireless proximity detector arrangement,
- Fig. 10 is a flowchart of a method of detecting and/or or quantitatively measuring a spatiotemporal movement of an object making use of the wireless proximity detector arrangement and
- Fig. 11 is a block diagram of an electronic device comprising a user interface equipped with a wireless proximity detector arrangement as described herein.

### Detailed description of the invention

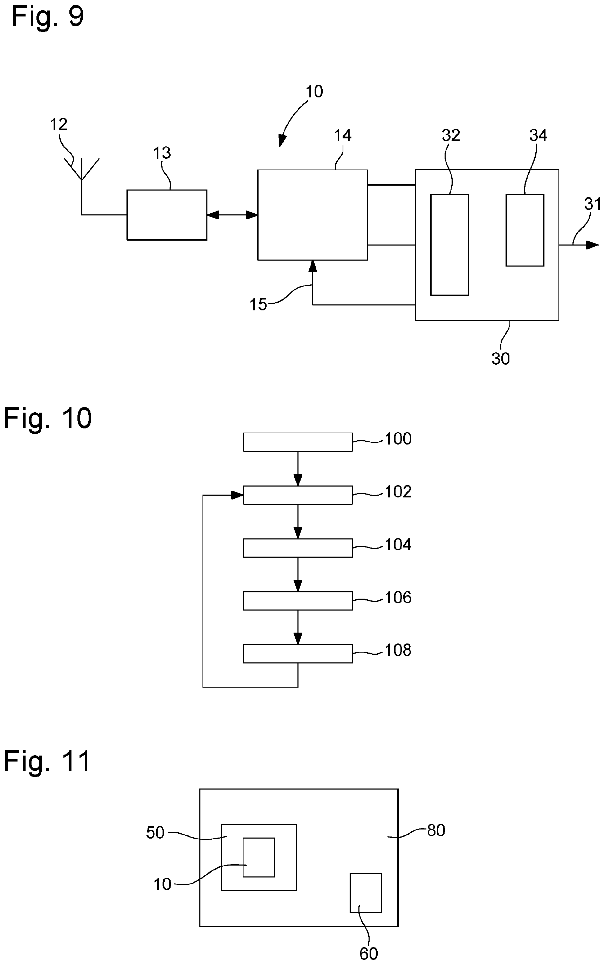

In Fig. 9, there is illustrated one example of a wireless proximity detector arrangement 10. The detector arrangement 10 comprises at least one antenna 12 connected to an impedance sensing circuit 14 by way of a coupling 13. The coupling 13 may comprise or provide an impedance matching circuit in order to enable measurement of the impedance of the antenna 12 by the impedance sensing circuit 14. An output of the impedance sensing circuit 14 is connected to a controller 30. The controller 30 is operable to process the output signals as provided by the impedance sensing circuit 14. The controller 30 may be also operable to control or at least partially control the impedance sensing circuit 14. For this, the controller 30 is connected to a control input 15 of the impedance sensing circuit 14.

Typically, the controller 30 comprises at least one digital processor in order to digitally process signals obtained from the impedance sensing circuit 14. By way of signal processing of the signals as obtainable from the impedance sensing circuit 14 the controller 30 may be operable to determine a relative position, a distance or a movement pattern of an object 11 in close vicinity to the antenna 12, wherein the movement or presence of the object 11 in close vicinity to the antenna 12 causes a variation of the impedance of the antenna 12, which impedance variations are measurable by the impedance sensing circuit 14. The controller 30 may be operable to provide signals and a signal output 31 mode which signals being indicative of a relative position, I distance and/or of a movement pattern of the object 11 relative to the antenna 12.

In some examples, the controller 30 comprises a digital storage 34 as well as a neural network 32. The neural network 32 may be operable to map at least one or a sequence of impedance signals as obtainable from the impedance sensing circuit 14 to a predefined or previously measured spatiotemporal movement pattern of the object 11 as stored or provided in the digital storage 34.

In effect, the controller 30 comprises an output via which there may be provided electrical or digital signals being indicative of a position or movement of the object 11 relative to the at least one antenna 12.

Typically, and as shown in Fig. 11, the proximity detector arrangement 10 is part of a user interface 50 of an electronic device 80. The electronic device 80 may be implemented as a portable electronic device. It may be battery driven. Insofar, the electronic device 80 may comprise a battery 60 to provide electrical energy for the user interface 50 as well as for further electronically implemented functional components of the electronic device 80. In some examples, the electronic device 80 is implemented as one of a mobile phone, as a smart phone, as a tablet computer, as a laptop computer or as a watch or other personal digital assistant.

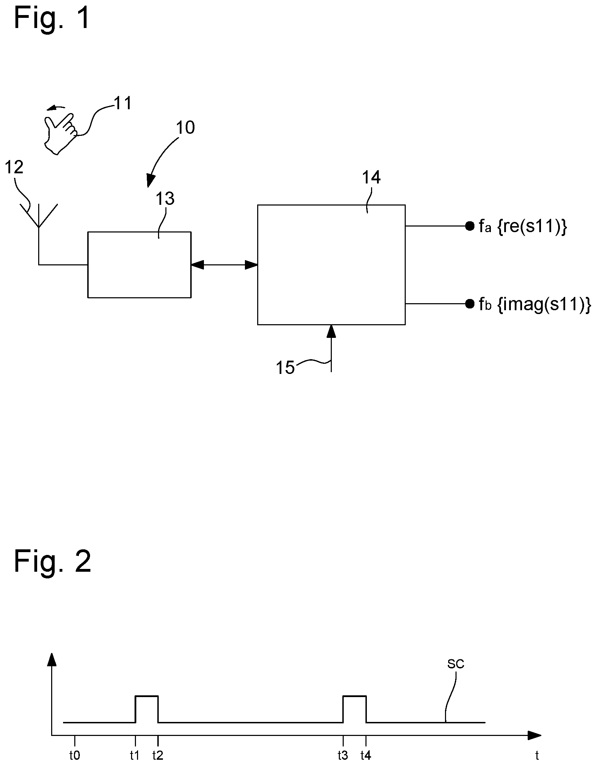

In Fig. 1 there is provided a block diagram of the at least one antenna 12, the coupling 13 and the impedance sensing circuit 14. The impedance sensing circuit 14 comprises a first output fa and a second output fb. Here, the first output fa is configured to provide a signal that is indicative of a real part of the antenna impedance. The further output fb is configured to provide a signal that is indicative of the imaginary part of the antenna impedance of the antenna 12.

The object 11 that is movable relative to the antenna may be a body part of a user, such as one or several fingers or such as a hand of a user. In some examples, the object 11 may be moved relative to the at least one antenna in accordance to predefined gestures or other predefined spatiotemporal movement patterns that might be detectable by the impedance sensing circuit 14.

In order to save energy and to reduce power consumption of the impedance sensing circuit 14 and hence of the entire wireless proximity detector arrangement 10 it is provided that the control input 15 of the impedance sensing circuit 14 is operable to at least temporally deactivate and/or operable to at least temporally activate an operation of the impedance sensing circuit 14. The control input 15 is controllable by the controller 30. It may be operated in a pulsed mode. As indicated in Fig. 2 there may be provided a control signal SC at the control input 15, which control signal SC is generated by the controller 30. At a time t0 the control signal SC is at a logical 0. At a time t1, the control signal SC is switched to a logical 1. Here, the control signal SC defines an activated state of the impedance sensing circuit 14. The control signal SC is active for the time period from t1 - t2. At the time t2 the control signal SC is again switched to a logical zero by way of which operation of the impedance sensing circuit is deactivated again.

At a further point of time t3 the impedance sensing circuit is switched on again by raising the control signal SC from logical 0 to logical 1 until lapse of a time interval t4-t3.

The time interval from t1 - t3 may represent a detection time interval or a sampling rate or sampling period. The time interval t2 - t1 may define an active detection time interval and the time interval t2 - t3 may define an inactive detection time interval. As indicated in Fig. 2, the inactive time interval is much larger than the active time interval. During the inactive detection time interval the power consumption of the impedance sensing circuit is at a minimum.

The pulsed operation of the impedance sensing circuit 14, during active detection time intervals, i.e. during the time interval t2 - t1 or during the time interval t4 - t3 serves to reduce power consumption of the impedance sensing circuit as a whole. This way, electric power consumption of the wireless proximity detector arrangement as well as battery lifetime of a battery 60 of a respective electronic device 80 can be prolonged or extended.

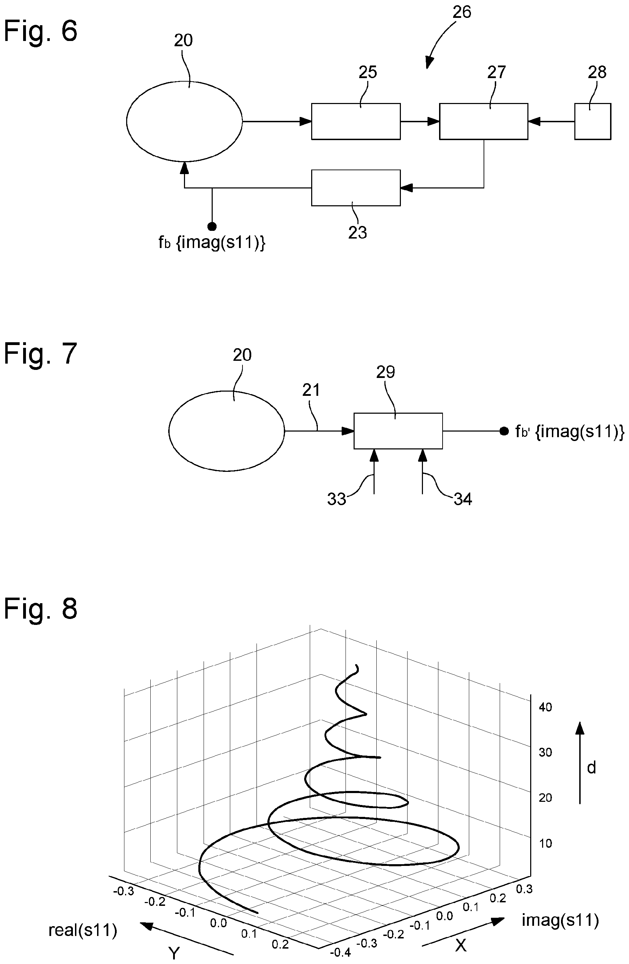

In Fig. 8, a spatial evolution of the complex reflection S11, thus reflecting the complex impedance of the antenna 12, is schematically illustrated. Here, along direction y, the real part of S11 is provided. Along direction x, the imaginary part of the reflection coefficient S11 is reflected. In the vertical direction, the distance in centimetres (cm) between the antenna 12 and an object 11 of the spatial evolution is shown. Such a spatial evolution of the antenna impedance may be indicative of a characteristic position or movement pattern of the object 11 when moved in close vicinity, i.e. in the nearfield of the at least one antenna 12.

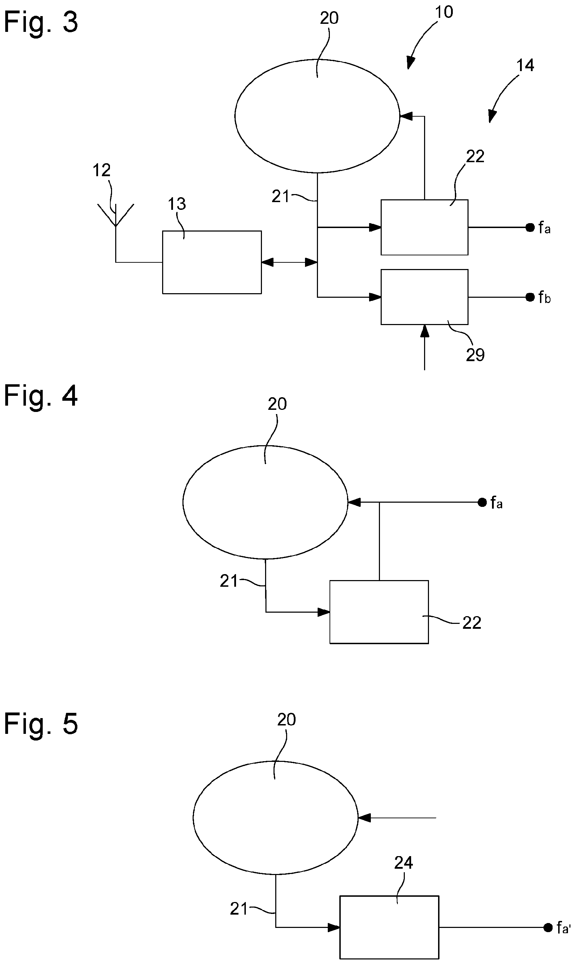

The real and imaginary parts of the antenna impedance may be measured by the impedance sensing circuit 14 as will be described below. Here and for measuring the antenna impedance the impedance sensing circuit 14 is provided with a measuring oscillator 20. The measuring oscillator 20 may be implemented as a modulated oscillator and/or as a voltage controlled oscillator, which may be operated and or near a resonance frequency of about 2.44 GHz. In the example of Fig. 3, the impedance sensing circuit 14 comprises an automatic gain controller 22, arranged in a feedback loop configuration with the measuring oscillator 20. Hence, an output of the automated gain controller 22 serves to provide a driving signal for operating or driving the oscillator 20 with at least one of a bias current and a bias voltage.

An output signal of the oscillator 20, which is directly connected to the coupling 13 and hence to the antenna 12 is provided as an input to the automatic gain controller 22. Typically, the automatic gain controller 22 is operated to provide a constant bias current or constant bias voltage at the input of the measuring oscillator 20. The respective control signals, e.g. in form of a bias current or bias voltage is measurable at fa of the automatic gain controller 22 and is directly indicative of measurable variations of the antenna impedance. This operation mode of the automatic gain controller is directly apparent from Fig. 4.

Alternative to the automatic gain controller 22 there may be provided an amplitude detector 24 as shown in Fig. 5. Here, the amplitude detector 24 is connected to the output of the measuring oscillator 20. The measuring oscillator 20 is operated or driven by a rather constant driving signal, e.g. by a constant driving or bias current. Any modifications or fluctuations of the antenna impedance may then lead to a respective measurable change of the amplitude of the oscillation signal as provided at the output 21 of the oscillator 21. As shown in Fig. 5, the output 21 of the measuring oscillator 20 is connected to an amplitude detector 24, which is directly operable to quantitatively measure any variations of the amplitude of the output signal of the measuring oscillator 20, which variations are typically induced by object-movement-induced variations or modifications of the antenna impedance. Accordingly, an output of the amplitude detector fa' is directly indicative of the real part of the reflection coefficient S11 of the antenna impedance.

The block diagrams according to Figs. 6 and 7 show two further approaches of measuring the complex part of the reflection coefficient S11 representing the antenna impedance. In the example of Fig. 6, the impedance sensing circuit 14 comprises a phase locked loop 26. Here, the output 21 of the measuring oscillator 20 is connected to a frequency divider 25, e.g. implemented as a RF frequency divider. An output of the frequency divider 25 is connected to a phase comparator 27, which is also connected to a reference frequency generator 28. The reference frequency generator 28 is operable to provide a well-defined reference frequency signal to the phase comparator 27.

The phase comparator 27 is operable to determine and/or to measure phase differences between the oscillations of the measuring oscillator 20 and the oscillation of the reference frequency generator 28. A respective comparison signal as generated by the phase comparator 27 is provided to the loop filter 23, which generates a respective frequency control signal, e.g. a frequency control voltage that is used to drive or to bias the measuring oscillator 20. Hence, the loop filter 23 provides a control or bias signal fb, which is directly indicative of the imaginary part of the reflection coefficient S11 of the antenna impedance.

Alternative to the solution as shown in Fig. 6, there may be also provided a frequency counter 29 connected to an output 21 of the measuring oscillator 20 year, the frequency counter 29 may be directly operable to measure a variation of the frequency of the measuring oscillator 20, which variations might be due to changes of the impedance of the antenna 12 coupled or connected to the measuring oscillator 20. Here, the frequency counter 29 comprises a reset input 33 and a count enable input 34. The input lines 33, 34 may be operated or driven by the controller 30. By setting the reset input 33 to a logical 1, the counter 29 is reset. By enabling the counter enabled input 34, e.g. by setting the input 34 to a logical 1, the frequency counter 29 starts counting. Typically, the count enable input 34 is active for and during a well-defined and rather precise time interval thereby allowing to directly measure any variations of the frequency of the measuring oscillator 20. From measurable variations of the frequency and/or phase of the oscillation of the measuring oscillator 20 there may be directly derived the imaginary part of the reflection coefficient S11 of the antenna impedance.

Both signals, the real part and the imaginary part of the measurable reflection coefficient fa, fb are provided as an input to the controller 30, which is operable to map the respective signal e.g. to a predefined spatiotemporal movement patterns of the object 11 relative to the at least one antenna 12.

As further indicated in Fig. 10 there is provided a method of detecting and/or quantitatively measuring a spatiotemporal movement of an object 11, e.g. of a hand or of a finger of a user relative to a wireless proximity detector arrangement 10. Here and in a first step 100 the wireless proximity detector arrangement 10 is provided. In a step 102 the impedance sensing circuit 14 of the wireless or contactless proximity detector arrangement 10 is activated for a predefined time interval. Thereafter and while being activated in step 104 there is conducted a quantitative measurement of variations of an antenna impedance over time by way of the impedance sensing circuit 14.

Thereafter and in step 106 the impedance sensing circuit is deactivated for a predefined time interval. Then, the method may continue with step 108, during which the impedance sensing circuit 14 remains inactive. Here, the controller 30 may simply conduct a counting operation until a predefined time interval has lapsed. Thereafter, the procedure returns to step 102, in which the impedance sensing circuit 14 is activated again. The impedance measurement conducted during step 104 may be directly evaluated or further processed by the controller 30 in order to assign or to map the measured signals to a predefined spatiotemporal movement pattern of the object 11 relative to the antenna 12. Regularly deactivating the impedance sensing circuit 14 helps to save energy and to prolong battery lifetime.

### Nomenclature

- 10: proximity detector arrangement
- 11: object
- 12: antenna
- 13: coupling
- 14: impedance sensing circuit
- 15: controller input
- 20: oscillator
- 21: oscillator output
- 22: automatic gain controller
- 23: loop filter
- 24: amplitude detector
- 25: frequency divider
- 26: phase locked loop
- 27: phase comparator
- 28: reference frequency generator
- 29: frequency counter
- 30: controller
- 31: output
- 32: neural network
- 33: reset input
- 34: count enable input
- 34: digital storage
- 50: user interface
- 60: battery
- 80: electronic device

## Claims

1. A wireless proximity detector arrangement (10) comprising:
- at least one antenna (12),
- an impedance sensing circuit (14) coupled to the antenna (12) and operable to quantitatively measure variations of an antenna impedance over time, and
- a controller (30) connected to the impedance sensing circuit (14) and operable to at least one of selectively deactivating and selectively activating the impedance sensing circuit (14) for a predefined time interval.

2. The wireless proximity detector arrangement (10) according to claim 1, wherein the controller (30) is operable to selectively activate the impedance sensing circuit (14) in a pulsed mode.

3. The wireless proximity detector arrangement (10) according to any one of the preceding claims, wherein the impedance sensing circuit (14) comprises a measuring oscillator (20) coupled to the antenna (12), and wherein variations of the antenna impedance are quantitatively measurable by measuring at least one of a control signal for operating the measuring oscillator (20), an amplitude signal of the measuring oscillator (20) and a frequency signal of the measuring oscillator (20).

4. The wireless proximity detector arrangement (10) according to claim 3, wherein the measuring oscillator (20) is coupled to an automatic gain controller (22) operable to fix a signal amplitude of the measuring oscillator (20).

5. The wireless proximity detector arrangement (10) according to claim 4, wherein the automatic gain controller (22) is operable to provide an amplitude control bias current to the measuring oscillator (20), which amplitude control bias current is subject to measurable variations in response to variations of the antenna impedance.

6. The wireless proximity detector arrangement (10) according to claim 3, wherein the impedance sensing circuit (14) comprises an amplitude detector (24) connected to an output of the measuring oscillator (20).

7. The wireless proximity detector arrangement (10) according to claim 6, wherein the measuring oscillator (20) is operable at a constant bias current and wherein the amplitude detector (24) is operable to measure variations of a signal amplitude of the measuring oscillator (20) in response to variations of the antenna impedance.

8. The wireless proximity detector arrangement (10) according to claim 3, wherein the impedance sensing circuit (14) comprises a phase locked loop (26) coupled to the oscillator (20) and coupled to a reference frequency generator (28).

9. The wireless proximity detector arrangement (10) according to claim 8, wherein the phase locked loop (26) is operable to fix a frequency of the oscillator (20) by way of a frequency control signal derivable by a comparison of the relative phases between an output signal of the oscillator (20) and a reference signal provided by the reference frequency generator (28).

10. The wireless proximity detector arrangement (10) according to claim 3, wherein the impedance sensing circuit (14) comprises a frequency counter (29) connected to an output of the oscillator (20).

11. The wireless proximity detector arrangement (10) according to claim 10, wherein the oscillator (20) is operable to vary an oscillation frequency in response to impedance variations of the antenna (12) and wherein the frequency counter (29) is operable to quantitatively measure the oscillation frequency variations.

12. The wireless proximity detector arrangement (10) according to any one of the preceding claims 3 - 11, wherein the impedance sensing circuit (14) operable to drive the oscillator (20) in a spread spectrum mode.

13. The wireless proximity detector arrangement (10) according to any one of the preceding claims, wherein the controller (30) comprises a neural network (32) and a digital storage (34), wherein the digital storage (34) is operable to store numerous temporal evolutions of impedance signals and wherein the neural network (32) is configured to map at least one temporal evolution of impedance signals to a characteristic spatiotemporal movement pattern of an object (11) relative to the antenna (12).

14. An electronic device (80) comprising a user interface (50) to control or to modify a function of the electronic device (80), wherein the user interface (50) comprises a wireless proximity detector arrangement (10) according to any one of the preceding claims.

15. A method of detecting and/or quantitatively measuring a spatiotemporal movement of an object (11) relative to a wireless proximity detector arrangement (10), the method comprising the steps of:
a) providing a wireless proximity detector arrangement (10) according to any one of the preceding claims 1-13,
b) activating an impedance sensing circuit (14) of the wireless proximity detector arrangement (10) for a predefined time interval,
c) quantitatively measuring variations of an antenna impedance over time by way of the impedance sensing circuit (14) coupled to the antenna (12) of the wireless proximity detector arrangement (10),
d) deactivating the impedance sensing circuit (14) for a predefined time interval,
e) optionally repeating the steps b), c) and d) and
f) deriving or quantitatively determining a spatiotemporal movement of the object (11) relative to the wireless proximity detector arrangement (10) on the basis of the variations of the antenna impedance.
